# EUROPEAN PATENT APPLICATION

(11) **EP 4 823 290 A1**
(43) Date of publication of application: **14.10.2026**
(21) Application number: 25188629.7
(22) Date of filing: 09.07.2025
(51) Int. Cl.: H10H 20/857, H10H 29/10, H10H 29/14, H10H 29/24, H10H 29/32, H10H 29/80

(54) **MULTI-CHIP LED PACKAGING STRUCTURE, BACKLIGHT MODULE, AND LIGHTING DEVICE**

(30) Priority: 09.04.2025 CN 202520668812 U
(71) Applicant: Nitelab Optoelectronics Co., Ltd., Foshan, Guangdong 528251 (CN)
(72) Inventor: LI, Wenjie, Foshan, Guangdong, 528251 (CN)
(74) Representative: KIPA AB

(57) **Abstract**

A multi-chip LED packaging structure, a backlight module, and a lighting device are disclosed. The multi-chip LED packaging structure includes a substrate, a peripheral LED chip, and a peripheral conductive wire. A first fixation section and a second fixation section are arranged on the substrate, the second fixation section includes a plurality of solder zones arranged radially, the first fixation section surrounds the second fixation section, an outer ring channel is formed between the first fixation section and the second fixation section, the first fixation section includes a plurality of wire bonding zones, and any one of the plurality of the wire bonding zones extends to between two of the plurality of the solder zones adjacent to the any one of the plurality of the wire bonding zones. The peripheral LED chip is arranged at the plurality of the solder zones, and arranged with peripheral electrodes. One end of the peripheral conductive wire is connected to the peripheral electrodes, and the other end of the peripheral conductive wire spans the outer ring channel and is connected to the plurality of the wire bonding zones. Extending the peripheral conductive wire to the wire bonding zone between two solder zones, instead of the linear or symmetrical wiring of the existing packaging structures, is beneficial for reducing packaging size and improving the compactness and applicability of LED packaging.

## Description

### FIELD

The present disclosure relates to the technical field of LED packaging, in particular to a multi-chip LED packaging structure, a backlight module, and a lighting device.

### BACKGROUND

COB (Chip-on-Board) packaging is an innovative technology addressing heat-dissipation challenges in light-emitting diodes (LEDs). A key of the COB packaging involves bonding an LED chip to a substrate using conductive or non-conductive adhesives, and then establishing an electrical connection using wire bonding. To protect the LED chip in air from environmental contamination or mechanical damage, the COB packaging further involves encapsulating the chip with bonding wires using encapsulant adhesive, which is termed soft encapsulation.

However, in existing COB packaging structures, wire bonding methods generally adopt linear wiring or symmetrical wiring, both of which require extending the bonding wires to a periphery of the LED chip, resulting in excessive encapsulant adhesive coverage during packaging, thereby increasing packaging size and affecting compactness and applicability of the packaging structures.

Therefore, the prior art still needs to be improved and developed.

### SUMMARY

In view of the above-mentioned deficiencies of the prior art, the present disclosure provides a multi-chip LED packaging structure, a backlight module, and a lighting device to solve the problem of large packaging size of the existing multi-chip LED packaging structures.

The technical schemes of the present disclosure are as follows.

A multi-chip LED packaging structure is disclosed, including:
a substrate, where a first fixation section and a second fixation section are arranged on the substrate, the second fixation section includes a plurality of solder zones arranged radially, the first fixation section surrounds the second fixation section, an outer ring channel is formed between the first fixation section and the second fixation section, the first fixation section includes a plurality of wire bonding zones, and any one of the plurality of the wire bonding zones extends between two of the plurality of the solder zones adjacent to the any one of the plurality of the wire bonding zones;
a peripheral LED chip, arranged at the plurality of solder zones, and arranged with peripheral electrodes; and
a peripheral conductive wire, where one end of the peripheral conductive wire is connected to the peripheral electrodes, and an other end of the peripheral conductive wire spans the outer ring channel and is connected to the plurality of wire bonding zones.

In some embodiments, one end of the peripheral LED chip faces a center position of the second fixation section, and an other end of the peripheral LED chip is arranged with the peripheral electrodes.

In some embodiments, four solder zones are provided and arranged in a cruciform shape with intervals, four peripheral LED chips are provided, one of the four peripheral LED chips is arranged on each solder zone;
at least eight peripheral conductive wires are provided, and at least one peripheral conductive wires is connected to each end of the peripheral electrodes.

In some embodiments, extension trajectories of the at least eight peripheral conductive wires are arranged in a circular or polygonal shape with intervals.

In some embodiments, the center position of the second fixation section is hollow to form a central zone, and the multi-chip LED packaging structure further includes:
a third fixation section, arranged at the central zone, where an inner ring channel is formed between the third fixation section and the second fixation section;
a central LED chip, arranged at the third fixation section, and arranged with central electrodes; and,
a central conductive wire, where one end of the central conductive wire is connected to the central electrodes, and an other end of the central conductive wire spans the inner ring channel and the outer ring channel and is connected to the plurality of the wire bonding zones.

In some embodiments, the first fixation section is a positive-electrode fixation section, and the second fixation section and the third fixation section are both negative-electrode fixation sections.

In some embodiments, the multi-chip LED packaging structure further includes an anode, a peripheral LED chip cathode, and a central LED chip cathode, and the anode, the peripheral LED chip cathode, and the central LED chip cathode are all arranged on the substrate and placed at one side of the substrate away from the second fixation section;
where a first conductive through hole is arranged at the substrate directly facing the first fixation section, and the first conductive through hole is configured to conduct the first fixation section and the anode;
a second conductive through hole is arranged at the substrate directly facing the second fixation section, and the second conductive through hole is configured to conduct the second fixation section and the peripheral LED chip cathode; and,
a third conductive through hole is arranged at the substrate directly facing the third fixation section, and the third fixation is configured to conduct the third fixation section and the central LED chip cathode.

In some embodiments, the multi-chip LED packaging structure further includes a heat-dissipation solder zone, the heat-dissipation solder zone and the second fixation section are respectively arranged at opposite sides of the substrate, and a proj ection area of the heat-dissipation solder zone on the substrate covers each of the plurality of solder zones.

A backlight module is disclosed, including the above multi-chip LED packaging structure.

A lighting device is disclosed, including the above multi-chip LED packaging structure.

### Beneficial effects:

In the present disclosure, the peripheral LED chip is arranged on the second fixation section, and the peripheral conductive wire led out from the peripheral electrodes faces the wire bonding zones, so as to conduct the positive and negative electrodes of the peripheral LED chip with the second fixation section and the first fixation section respectively. The wire bonding zone is located between two solder zones adjacent to the wire bonding zone, so the peripheral conductive wire is led out transversely and not led out to an outside of the peripheral LED chip. The packaging size of the substrate is reduced, thereby improving the compactness and applicability of the multi-chip LED packaging structure, especially in small-sized module applications.

### BRIEF DESCRIPTION OF THE DRAWINGS

FIG. 1 is a structural schematic diagram of a multi-chip LED packaging structure in the present disclosure.
FIG. 2 is another structural schematic diagram of the multi-chip LED packaging structure in the present disclosure.

Attached drawing marks: 10. substrate; 11. second fixation section; 111. solder zone; 12. first fixation section; 121. wire bonding zone; 13. outer ring channel; 14. third fixation section; 15. inner ring channel; 20. peripheral LED chip; 21. peripheral electrode; 30. peripheral conductive wire; 40. central LED chip; 41. central electrodes; 50. central conductive wire; 60. anode; 70. peripheral LED chip cathode; 80. central LED chip cathode; 90. heat-dissipation solder zone.

### DETAILED DESCRIPTION OF THE EMBODIMENTS

The following illustrates the implementation methods of the present disclosure with reference to the accompanying drawings and the preferred embodiments. Those skilled in the art can easily understand other advantages and effects of the present disclosure from the contents disclosed in the detailed description. The present disclosure can also be implemented or applied through different embodiments, and various details in the detailed description can be modified or changed based on different perspectives and applications without departing from the spirits of the present disclosure. It should be understood that the preferred embodiments are only intended to illustrate the present disclosure and not to limit the protection scope of the present disclosure.

It should be noted that the drawings provided in the following embodiments only illustrate the basic concepts of the present disclosure in a schematic manner. Therefore, the drawings only show the components related to the present disclosure and are not drawn according to the quantity, shape, and size of the components in actual implementation. The shape, quantity, and proportion of each component in actual implementation can be changed, and the shape and layout of the components can be more complex.

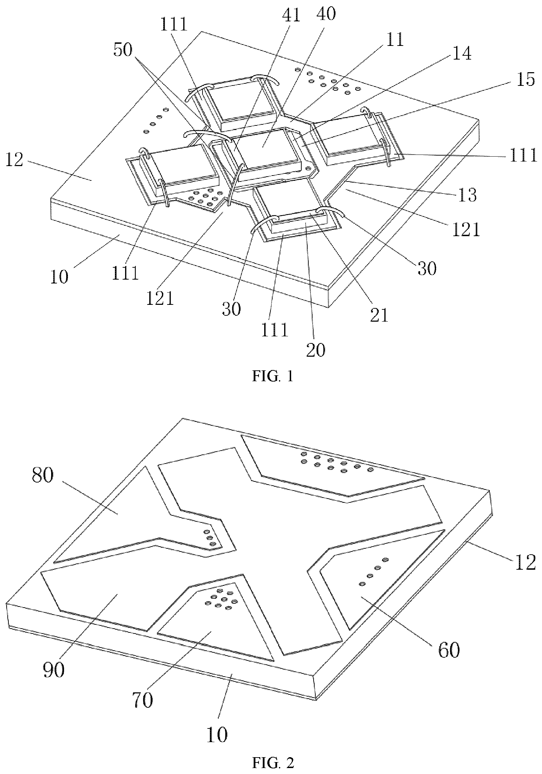

As shown in FIG. 1, an embodiment of the present disclosure provides a multi-chip LED packaging structure, including a substrate 10, a peripheral LED chip 20, and a peripheral conductive wire 30. The substrate 10 is arranged with a second fixation section 11 and a first fixation section 12. The second fixation section 11 includes a plurality of solder zones 111 arranged radially. The first fixation section 12 surrounds the second fixation section 11. An outer ring channel 13 is formed between the first fixation section 12 and the second fixation section 11. The first fixation section 12 includes a plurality of wire bonding zones 121, with the wire bonding zone 121 extending to between two solder zones 111 adjacent to the wire bonding zone. The peripheral LED chip 20 is arranged on the solder zones 111. The peripheral LED chip 20 is arranged with peripheral electrodes 21. One end of the peripheral conductive wire 30 is connected to the peripheral electrodes 21, and an other end of the peripheral conductive wire 30 spans the outer ring channel 13 and is connected to the wire bonding zones 121.

In the present embodiment, the substrate 10 is provided with the second fixation section 11 and the first fixation section 12. The second fixation section 11 is radially placed in the center of the substrate. The first fixation section 12 surrounds the second fixation section 11 but does not make contact with the second fixation section 11. The second fixation section 11 serves as negative-electrode solder pad, and the first fixation section 12 serves as positive-electrode solder pad, both of which play a conductive role.

In the present embodiment, the peripheral LED chip 20 is arranged on the second fixation section 11 and may be fixed by adhering using conductive adhesive or soldering; at the same time, a negative electrode of the peripheral LED chip 20 and the second fixation section 11 are conductive. The peripheral conductive wire 30 led out from the peripheral electrodes 21 faces the wire bonding zones 121, thereby conducting the first fixation section 12. That is to say, a positive electrode of the peripheral LED chip 20 and the first fixation section 12 are conductive, and the negative electrode of the peripheral LED chip 20 and the second fixation section 11 are conductive; at the same time, the second fixation section 11 and the first fixation section 12 are separated by the outer ring channel 13 to avoid short circuits.

The second fixation section 11 is composed of the plurality of solder zones 111, with the wire bonding zone 121 placed between two solder zones 111 adjacent to the wire bonding zone. The extension direction of the peripheral conductive wire 30 is transverse and does not extend toward an outside of the peripheral LED chip 20. Therefore, unlike expanding a dispensing area to the outside of an LED chip in the prior art, the dispensing area in the present embodiment only includes the second fixation section 11 and the wire bonding zones 121 of the first fixation section 12. Reducing a packaging size on the substrate 10 improves the compactness and applicability of the multi-chip LED packaging structure, especially in small-sized module applications, which is beneficial for producing highly integrated display products and increasing market value.

The peripheral conductive wire 30 disclosed in the present embodiment includes but is not limited to gold wire. By utilizing the advantages of good conductivity and stability of gold wire, the structure stability can be improved and the structure service life can be extended.

As shown in FIG. 1, in an embodiment of the present disclosure, one end of the peripheral LED chip 20 faces a center of the second fixation 11, and an other end of the peripheral LED chip 20 is arranged with the peripheral electrodes 21. The second fixation section 11 in the present embodiment is composed of the plurality of solder zones 111 arranged radially, so that the center of the peripheral LED chip 20 is a connection position. The plurality of solder zones 111 are connected to each other, and a gap between two adjacent solder zones 111 is small, while a gap at the edge is large. A distance between two adjacent solder zones 111 is relatively far.

In the present embodiment, one peripheral LED chip 20 may be arranged at any one of the solder zones 111, or a plurality of peripheral LED chips 20 may be arranged at the plurality of solder zones 111. In order to make reasonable use of space, the peripheral electrodes 21 are arranged at a far end of the peripheral LED chip 20, and the far end is the one end of the peripheral LED chip 20 facing an edge position of the second fixation section 11. Therefore, it allows for greater operating space when arranging the peripheral conductive wire 30, so as to avoid interference between the peripheral conductive wires 30 on two adjacent peripheral LED chips 20.

As shown in FIG. 1, in an embodiment of the present disclosure, four solder zones 111 are provided; the four solder zones 111 are arranged in a cruciform shape with intervals. Four peripheral LED chips 20 are provided; one peripheral LED chip 20 is arranged on each solder zone 111. At least eight peripheral conductive wires 30 are provided; each end of the peripheral electrodes 21 is connected to at least one peripheral conductive wire 30. In one implementation of the present embodiment, more peripheral conductive wires 30 can be provided according to chip current size.

The second fixation section 11 disclosed in the present embodiment has a cruciform shape as a whole, with the four solder zones 111 arranged in sequence with intervals. At the same time, the four peripheral LED chips 20 are arranged in a cruciform shape, which can emit uniform array light and improve display brightness and uniformity.

In the present embodiment, each peripheral LED chip 20 leads out at least two peripheral conductive wires 30, so it is necessary to arrange two connection positions for at least two peripheral conductive wires 30 within one wire bonding zone 121. By providing the four solder zones 111, a gap angle between two adjacent peripheral LED chips 20 is large, which means that the wire bonding zone 121 has large area to facilitate connecting the peripheral conductive wire 30. Overall, the spatial arrangement of the multi-chip LED packaging structure is reasonable, which is conducive to reducing processing difficulty.

In an embodiment of the present disclosure, extension trajectories of the at least eight peripheral conductive wires 30 are arranged in a circular or polygonal shape with intervals. In the present embodiment, two peripheral conductive wires 30 connected to any one peripheral LED chip 20 extend toward two sides, respectively. Totally eight conductive wires are arranged in a circular or polygonal shape, and the overall trajectory of the eight conductive wires is close to a circular shape, reducing the packaging size and thus reducing packaging volume, which is conducive to improving the compactness of the packaging structure and integrating the production of display devices.

As shown in FIG. 1, in an embodiment of the present disclosure, a center position of the second fixation section 11 is hollow to form a central zone. The multi-chip LED packaging structure includes a third fixation section 14, a central LED chip 40, and a central conductive wire 50. The third fixation section 14 is arranged at the central zone. An inner ring channel 15 is formed between the third fixation section 14 and the second fixation section 11. The central LED chip 40 is arranged on the third fixation section 14. The central LED chip 40 is arranged with a central electrode 41. One end of the central conductive wire 50 is connected to the central electrode 41. An other end of the central conductive wire 50 spans the inner ring channel 15 and the outer ring channel 13, and is connected to the wire bonding zones 121.

In the present embodiment, by providing the central LED chip 40 at the center position of the second fixation section 11, a light source distribution of the entire packaging structure is more uniform. The plurality of the peripheral LED chips 20 surround the central LED chip 40, so that the emitted light is more uniform during operation, thereby reducing dark areas.

In the present embodiment, the third fixation section 14 is arranged on the substrate 10, and the central LED chip 40 is adhered to the third fixation section 14 using conductive adhesive. The central conductive wire 50 is uesd to connected an other electrode of the central LED chip 40 to the first fixation section 12, so as to make the central LED chip 40 and the first fixation section 12 conductive, so that the peripheral LED chip 20 and the central LED chip 40 share the same electrodes, thereby simplifying complexity of wiring and facilitating the improvement of processing efficiency.

In the present embodiment, the third fixation section 14, the second fixation section 11, and the first fixation section 12 are sleeved in sequence without contacting each other, so that circuits of the peripheral LED chip 20 and the central LED chip 40 are orderly conducted and can be used for a long time. More importantly, the central LED chip 40 is arranged at an inner side of the second fixation section 11, so that the central conductive wire 50 can span the inner ring channel 15 and the outer ring channel 13 to connect to the wire bonding zone 121. That is to say, the extension trajectory of the central conductive wire 50 is also within the wire bonding zone 121, so that the packaging size of the entire packaging structure is kept within a minimum range, further achieving the effect of optimizing the packaging volume, which is conducive to the integration of the multi-chip LED packaging structure.

In the present embodiment, the peripheral LED chip 20 and the central LED chip 40 can employ the same chip. The peripheral conductive wire 30 and the central conductive wire 50 are both made of the same material, such as gold wire, in order to optimize the material and save processing costs.

In an embodiment of the present disclosure, the first fixation section 12 is a positive-electrode fixation section, and the second fixation section 11 and the third fixation section 14 are both negative-electrode fixation sections. In the present embodiment, the first fixation section 12 serves as electrodes shared by both the peripheral LED chip 20 and the central LED chip 40, thereby saving space and simplifying structure. The second fixation section 11 conducts the peripheral LED chip 20, and the third fixation section 14 conducts the central LED chip 40 for independent control, thereby precising the voltage distribution and increasing the flexibility in controlling the light emission mode.

In addition, in the present embodiment, the peripheral LED chip 20 and the central LED chip 40 are both wire-bonded chips. Negative electrodes of the peripheral LED chip 20 and the central LED chip 40 are respectively placed close to a chip bottom end and are respectively directly connected to the second fixation section 11 and the third fixation section 14, thereby reducing traces. Positive electrodes of the peripheral LED chip 20 and the central LED chip 40 are respectively placed at chip top end, and a conductive wire is led out through an electrode plate to the common positive electrode, thereby making wiring layout more reasonable.

As shown in FIGs. 1 and 2, in an embodiment of the present disclosure, the multi-chip LED packaging structure includes an anode 60, a peripheral LED chip cathode 70, and a central LED chip cathode 80. The anode 60, the peripheral LED chip cathode 70, and the central LED chip cathode 80 are all arranged on the substrate 10 and placed at one side of the substrate 10 away from the second fixation section 11. A first conductive through hole is arranged at a position of the substrate 10 directly facing the first fixation section 12, which is used to conduct the first fixation section 12 and the anode 60. A second conductive through hole is arranged at a position of the substrate 10 directly facing the second fixation section 11, which is used to conduct the second fixation section 11 and the peripheral LED chip cathode 70. A third conductive through hole is arranged at a position of the substrate 10 directly facing the third fixation section 14, which is used to conduct the third fixation section 14 and the central LED chip cathode 80.

In the multi-chip LED packaging structure of the present embodiment, the substrate 10 has limited front space due to the presence of a plurality of chips on the substrate. By providing the first, second, and third conductive through holes to connect front and back of the substrate 10, the anode 60 and the first fixation section 12, the second fixation section 11 and the peripheral LED chip cathode 70, and the third fixation section 14 and the central LED chip cathode 80 are respectively conductive, thereby facilitating designing circuit patterns on the back of the substrate 10, and making higher space utilization and compactness of the packaging structure.

As shown in FIG. 2, in an embodiment of the present disclosure, the multi-chip LED packaging structure includes a heat-dissipation solder zone 90. The heat-dissipation solder zone 90 and the second fixation section 11 are arranged at opposite sides of the substrate 10, and a projection area of the heat-dissipation solder zone 90 on the substrate 10 covers each solder zone 111.

In the present embodiment, a position of the heat-dissipation solder zone 90 corresponds to a position of the peripheral LED chip 20, so as to improve local heat-dissipation efficiency, maintain good light-emitting efficiency of the LED chip, increase reliability, and prolong a service life of the packaging structure.

In summary, the multi-chip LED packaging structure disclosed in the present disclosure can use different packaging processes such as SMD LED (Surface Mount Device Light Emitting Diode) and COB, and has a wide application range, which can be applied to various high-density packaging scenarios. For example, for LED lighting modules, it can reduce the packaging volume and make the structure of LED lighting modules more compact; for car-mounted LED, it helps optimize the layout of LED light groups and adapts to the installation needs of narrow spaces inside car headlights; for micro projection devices, it can reduce the packaging size of LED light sources, improve the space utilization of LEDs, and optimize the structural layout of projection devices.

In an embodiment of the present disclosure, a backlight module is disclosed, including the multi-chip LED packaging structure as described above.

In an embodiment of the present disclosure, a lighting device is disclosed, including the multi-chip LED packaging structure as described above.

In summary, the present disclosure provides a multi-chip LED packaging structure, including a substrate 10, a peripheral LED chip 20, and a peripheral conductive wire 30. The substrate 10 is arranged with a second fixation section 11 and a first fixation section 12. The second fixation section 11 includes a plurality of solder zones 111 arranged radially. The first fixation section 12 surrounds the second fixation section 11, and an outer annular channel 13 is formed between the first fixation section 12 and the second fixation section 11. The first fixation section 12 includes a plurality of wire bonding zones 121, and the wire bonding zone 121 extends to between two solder zones 111 adjacent to the wire bonding zone 121. The peripheral LED chip 20 is arranged at the solder zone 111. The peripheral LED chip 20 is arranged with peripheral electrodes 21. One end of the peripheral conductive wire 30 is connected to the peripheral electrodes 21, and an other end of the peripheral conductive wire 30 spans the outer ring channel 13 and is connected to the wire bonding zone 121. In the present embodiment, the wire bonding zone 121 is located between two solder zones 111 adjacent to the wire bonding zone 121, so the peripheral conductive wire is led out transversely and not led out to the outside of the peripheral LED chip 20. The packaging size of the substrate 10 is reduced, thereby improving the compactness and applicability of the multi-chip LED packaging structure, especially in small-sized module applications.

It should be understood that the applications of the present disclosure are not limited to the above examples. For those ordinary skilled in the art, improvements or changes can be made based on the above description, but all these improvements and changes should fall within the protection scope of the appended claims of the present disclosure.

## Claims

1. A multi-chip LED packaging structure, comprising:
a substrate, wherein a first fixation section and a second fixation section are arranged on the substrate, the second fixation section comprises a plurality of solder zones arranged radially, the first fixation section surrounds the second fixation section, an outer ring channel is formed between the first fixation section and the second fixation section, the first fixation section comprises a plurality of wire bonding zones, and any one of the plurality of the wire bonding zones extends between two of the plurality of the solder zones adjacent to the any one of the plurality of the wire bonding zones;
a peripheral LED chip, arranged at the plurality of solder zones, and arranged with peripheral electrodes; and,
a peripheral conductive wire, wherein one end of the peripheral conductive wire is connected to the peripheral electrodes, and an other end of the peripheral conductive wire spans the outer ring channel and is connected to the plurality of wire bonding zones.

2. The multi-chip LED packaging structure according to claim 1, wherein one end of the peripheral LED chip faces a center position of the second fixation section, and an other end of the peripheral LED chip is arranged with the peripheral electrodes.

3. The multi-chip LED packaging structure according to claim 2, wherein four solder zones are arranged in a cruciform shape with intervals, four peripheral LED chips are arranged, one of the four peripheral LED chips is arranged on each solder zone;
at least eight peripheral conductive wires are arranged, and at least one peripheral conductive wire is connected to each end of the peripheral electrodes.

4. The multi-chip LED packaging structure according to claim 3, wherein extension trajectories of the at least eight peripheral conductive wires are arranged in a circular or polygonal shape with intervals.

5. The multi-chip LED packaging structure according to claim 1, wherein a center position of the second fixation section is hollow to form a central zone, and the multi-chip LED packaging structure further comprises:
a third fixation section, arranged at the central zone, wherein an inner ring channel is formed between the third fixation section and the second fixation section;
a central LED chip, arranged at the third fixation section, and arranged with central electrodes; and,
a central conductive wire, wherein one end of the central conductive wire is connected to the central electrodes, and an other end of the central conductive wire spans the inner ring channel and the outer ring channel and is connected to the plurality of the wire bonding zones.

6. The multi-chip LED packaging structure according to claim 5, wherein the first fixation section is a positive-electrode fixation section, and the second fixation section and the third fixation section are both negative-electrode fixation sections.

7. The multi-chip LED packaging structure according to claim 6, wherein the multi-chip LED packaging structure further comprises an anode, a peripheral LED chip cathode, and a central LED chip cathode, and the anode, the peripheral LED chip cathode, and the central LED chip cathode are all arranged on the substrate and placed at one side of the substrate away from the second fixation section;
wherein a first conductive through hole is arranged at the substrate directly facing the first fixation section, and the first conductive through hole is configured to conduct the first fixation section and the anode;
a second conductive through hole is arranged at the substrate directly facing the second fixation section, and the second conductive through hole is configured to conduct the second fixation section and the peripheral LED chip cathode; and,
a third conductive through hole is arranged at the substrate directly facing the third fixation section, and the third fixation is configured to conduct the third fixation section and the central LED chip cathode.

8. The multi-chip LED packaging structure according to any one of claims 1-7, wherein the multi-chip LED packaging structure further comprises a heat-dissipation solder zone, the heat-dissipation solder zone and the second fixation section are respectively arranged at opposite sides of the substrate, and a projection area of the heat-dissipation solder zone on the substrate covers each of the plurality of solder zones.

9. A backlight module, comprising the multi-chip LED packaging structure according to any one of claims 1-8.

10. A lighting device, comprising the multi-chip LED packaging structure according to any one of claims 1-8.
